(19) Europäisches Patentamt
European Patent Office
Office européen des brevets

(11) Veröffentlichungsnummer : **0 320 742 B1**

(12) # EUROPÄISCHE PATENTSCHRIFT

(45) Veröffentlichungstag der Patentschrift :
**05.04.95 Patentblatt 95/14**

(51) Int. Cl.$^6$ : **G03F 7/20,** G03F 7/26

(21) Anmeldenummer : **88120308.7**

(22) Anmeldetag : **06.12.88**

(54) **Verfahren zur Nachbehandlung von entwickelten Reliefdruckformen für den Flexodruck.**

(30) Priorität : **12.12.87 DE 3742275**

(43) Veröffentlichungstag der Anmeldung :
**21.06.89 Patentblatt 89/25**

(45) Bekanntmachung des Hinweises auf die Patenterteilung :
**05.04.95 Patentblatt 95/14**

(84) Benannte Vertragsstaaten :
**DE FR GB**

(56) Entgegenhaltungen :
**US-A- 3 723 120**
**US-A- 4 189 323**
**US-A- 4 202 696**
**US-A- 4 400 460**
**US-A- 4 619 998**

(73) Patentinhaber : **E.I. DU PONT DE NEMOURS AND COMPANY**
**1007 Market Street**
**Wilmington Delaware 19898 (US)**

(72) Erfinder : **Hermann, Heinz, Dr.**
**Am Güldenplan 15**
**D-6200 Wiesbaden (DE)**

(74) Vertreter : **Pistor, Wolfgang et al**
**Du Pont de Nemours (Deutschland) GmbH**
**Patentabteilung**
**Dornhofstrasse 10**
**D-63263 Neu-Isenburg (DE)**

EP 0 320 742 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung betrifft ein Verfahren zur Nachbehandlung von entwickelten Reliefdruckformen für den Flexodruck, die in bekannter Wiese nachbelichtet sind.

Lichtempfindliche Flexodruckplatten sind gewöhnlich mehrschichtig aufgebaut und setzen sich zumeist aus einem maßbeständigen Schichtträger, einer Haftschicht, einer zumeist 0,5-7 mm dicken photopolymerisierbaren oder photovernetzbaren elastomeren Schicht, die ein elastomeres Bindemittel, polymerisierbare Monomere, einen Photoinitiator und ggf. Zusätze enthält, einer nichtklebenden Deckschicht (Polymer-Overcoat) und einer abtrennbaren Schutzfolie zusammen.

Der Schichtträger kann aus Metall oder vorzugsweise einer maßbeständigen transparenten Kunststoffolie bestehen und dient zur Verstärkung und Einhaltung der Maßhaltigkeit der elastomeren Schicht beim Druck, die bis zu mehrere Millimeter dick sein kann. Um die lichthärtbare Schicht fest auf dem Schichtträger zu verankern, ist eine Haftschicht erforderlich, die z.B. aus einem Ein- oder Zweikomponentenkleber auf Polyurethan- oder Polychloroprenbasis, wie es in den DE-A-31 00 175, 31 07 741, 24 44 118 und 31 37 416 beschrieben ist, aus einer polymerisierbaren Schicht (US-A-3,036,913) oder einem Gemisch aus Polyvinylchlorid und Polyvinylacetat (DE-A-33 19 676) besteht. Gemische aus speziellen Polyestern und Polyamiden, Polyurethanen oder Polyolefinen sind für den gleichen Zweck aus der EP-A-0 064 564 bekannt. Haftschichten, die chlorsulfoniertes Polyethylen enthalten, sind aus der P 37 40 432.6 (int.Nr. Hoe 87/K080) bekannt.

Bei bildmäßiger Belichtung solcher lichtempfindlichen Flexodruckplatten werden die Bildstellen der Photopolymerschicht photopolymerisiert bzw. photovernetzt. Nach Auswaschen der ungehärteten Schichtbereiche mittels eines geeigneten Lösemittels erhält man eine gummielastische Reliefdruckform, die in der Regel durch eine Nachbelichtung mit aktinischem Licht weiter verfestigt werden kann.

An der Schichtoberfläche der Photopolymerschicht verläuft die Photopolymerisation vermutlich infolge der dort vorhandenen erhöhten Sauerstoffkonzentration nur unvollständig. Eine unvollständige Polymerisation ist an der Klebrigkeit der Plattenoberfläche erkennbar.

Eine klebrige Oberfläche stört bei der Anwendung der Platten als Druckplatten: Beim Druckvorgang bleibt zum Beispiel Papierstaub an den klebrigen Platten haften, eine Verminderung der Druckqualität ist die Folge. Auf der anderen Seite lassen sich klebrige aufgestapelte Platten nur mit Mühe voneinander trennen.

Die störende Oberflächenklebrigkeit kann nach verschiedenen Methoden beseitigt werden.

In der Praxis ist eine Nachbehandlung mit einer wäßrigen Lösung, die freies Halogen oder halogenfreisetzende Stoffe enthält, üblich. So kann die Platte zum Beispiel in einer wäßrigen Lösung von NaOCl und HCl gebadet werden oder mit einer Bromlösung (DE-C-28 23 300), einer netzmittelhaltigen Bromlösung (DE-A-35 21 955) oder einer Jodlösung (DE-A-30 71 141) behandelt werden. Auch eine Doppelbehandlung zuerst in einem Brom- bzw. Jod-Bad und anschließend in einem NaOCl/HCl-Bad wird empfohlen (EP-A-0 096 835 = US-A-4,451,553).

Die in diesen Verfahren verwendeten Lösungen sind aber aggressiv und wirken korrodierend.

Daneben kann man die Druckform auch mit einer Lösung aus Carbonylverbindungen, die in UV-Licht Radikale bilden, behandeln und anschließend mit kurzwelligem UV-Licht bestrahlen (US-A-4,202,696). Der Nachteil dieses Verfahrens ist aber die Verwendung von gesundheitsschädlichem UV-Licht (200-300 nm), das nur von Speziallampen erzeugt wird. Schließlich sind die Belichtungszeiten mit bis zu 15 Minuten relativ lang.

Nach einer anderen Methode belichtet man die klebrige Druckform mit UV-Licht, während sie sich in einem wäßrigen Bad, das photopolymerisierbare Monomere und Photoinitiatoren enthält, befindet (WO 86/02177).

Nachteil dieser Methode ist, daß eine aufwendige spezielle Apparatur notwendig wird und die verwendeten Lösungen bzw. Dispersionen nicht haltbar sind.

Schließlich kann man die Druckform mit einer Lösung, die nicht klebrige Bindemittel, photopolymerisierbare Monomere und Photoinitiatoren enthält, lackieren und belichtet anschließend mit UV-Licht (DE-A-37 04 067). Diese Überzüge sind aber relativ hart und mindern die Flexibilität der Druckform.

Die meistausgeführte Nachbehandlung im bromhaltigen Bad verstärkt neben den schon beschriebenen Nachteilen auch die Neigung der Druckformen zur Bildung von Rissen bei Kontakt mit ozonhaltiger Luft. Rißbildung kann die Druckform unbrauchbar machen. Die Zahl der Risse und ihre Stärke sind abhängig von der Zusammensetzung der elastomeren Photopolymerschicht. Durch Verwendung von Antiozonantien, von Weichmachern und von Elastomeren, die keine olefinischen Doppelbindungen enthalten, kann die Neigung zur Rißbildung vermindert werden. Es ist jedoch schwierig, geeignete, verträgliche und ungiftige Mischungen zu finden, die bei der Photopolymerisation Reliefdruckformen mit guten mechanischen Eigenschaften und gleichzeitig geringer Ozon-Empfindlichkeit liefern.

Die Stabilität gegen Ozon ist bei fast allen handelsüblichen Photopolymer-Flexodruckplatten verbesserungsbedürftig, auch wenn die Photopolymerschicht einen hohen Anteil an Antiozonantien enthält. Es wurden deshalb auch verschiedene Nachbehandlungsmethoden vorgeschlagen, die die Bildung von Rissen in schon

klebefrei gemachten Druckformen während der Lagerung verhindern sollen.

Ein solches Verfahren betrifft die Behandlung der Druckformen mit Lösungen von Nickel- oder Zink-dialkyl-dithiocarbamaten in organischem Lösemittel (EP-A-0 137 331), Nachteil ist aber die physiologische Bedenklichkeit der verwendeten Lösungen.

Nach anderen Verfahrensweisen wird die Reliefdruckform mit einer alkoholischen Polyamidlösung lackiert (DE-A-34 15 044) oder nach der DE-A-35 12 632 mit flüssigen Polyglykolethern behandelt. Diese Verfahren können zwar die Druckform vor oder auch nach dem Druckvorgang schützen, während des Druckvorgangs werden aber die gegen Ozon schützenden Substanzen durch die Lösemittel der Druckfarben aus den Druckformen ausgewaschen.

Es bestand daher die Aufgabe, ein Verfahren zur Nachbehandlung von entwickelten Reliefdruckformen bereitzustellen, welches

- schnell und einfach durchführbar ist,
- keine aggressiven Lösungen zur Anwendung bringt und
- eine dauerhafte Erhöhung der Resistenz der Druckformen gegen ozonhaltige Luft bewirkt und schließlich
- die Oberflächenklebrigkeit der Druckform beseitigt.

Gelöst wird die Aufgabe durch Bereitstellen eines Verfahrens zur Nachbehandlung von entwickelten Reliefdruckformen für den Flexodruck, die in bekannter Weise nachbelichtet werden, und welches dadurch gekennzeichnet ist, daß die Reliefdruckformen mit einer Lösung im wesentlichen bestehend aus einem organischen Lösemittel und einem gelösten Aryl- bzw. Hetaryl-bis-trihalogenmethyl-s-triazin der allgemeinen Formel I behandelt wird,

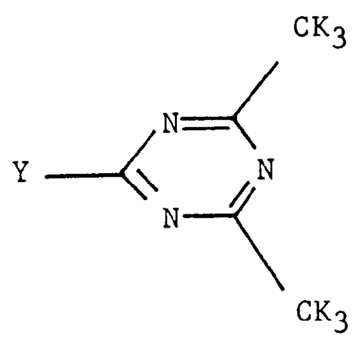

(I)

die Reliefdruckform getrocknet wird und anschließend kurzzeitig mit UV-Licht nachbelichtet wird.

Das erfindungsgemäße Verfahren ist wirksam bei allen lichthärtbaren Photopolymer-Flexodruckformen, die eine klebrige Oberfläche besitzen. Darüber hinaus kann es auch angewendet werden bei anderen, nicht elastomeren klebrigen Photopolymerdruckformen. Generell eignet sich das Verfahren zur Verminderung der Klebrigkeit beliebiger fester Polymerschichten.

Die Verbindungen der allgemeinen Formel I enthalten als

Y einen ggf. substituierten aromatischen oder heterocyclischen aromatischen, ggf. über eine konjugierte Alkenylenkette, insbesondere ($C_2$-$C_6$)Alkenylen, gebundenen Rest oder einen ggf. partiell hydrierten Rest, der über ein ungesättigtes Ring-C-Atom gebunden ist und wiederum ggf. substituiert sein kann, insbesondere durch Aryl oder Ar($C_2$-$C_6$)alkenylen, und als

K ein Chlor-, Brom oder Jodatom, vorzugsweise ein Chloratom.

Als Substituenten sind z.B. zu nennen:

Halogen, besonders Chlor und Brom, niedere, ggf. substituierte Alkylreste mit vorzugsweise 1 - 3 C-Atomen, ggf. substituierte Arylreste, Nitro-, Sulfonyl-, Alkylmercapto-, Phenylmercapto-, Acyl-, Aryloxy-, Hydroxy- und vorzugsweise Alkoxyreste, besonders bevorzugt ($C_1$-$C_8$)-Alkoxyreste, die wiederum durch Halogen, Phenyl oder Phenoxy substituiert und in denen einzelne Methylengruppen durch O- oder S-Brücken ersetzt sein können, sowie Phenoxy-, Cycloalkoxy- und Alkenyloxyreste.

Als aromatische Reste können Phenyl und zwei oder mehrkernige aromatische Reste verwendet werden, aber auch heterocyclische aromatische Verbindungen sind mitumfaßt.

Beispiele für geeignete aromatische oder heteroaromatische Reste sind: Naphthalin, Anthracen, Phenanthren, Chinolin, Isochinolin, Benzofuran, Benzopyran, Dibenzofuran, Benzothiophen,Dibenzothiophen, Acenaphthen, Benzoxazol, Fluoren, Tetrahydrophenanthren und Dihydrophenalen.

Ist Y ein Aryl- bzw. Aralkenyl-Rest, so ist dieser bevorzugt substituiert durch Halogen, insbesondere Chlor,

Alkoxy, insbesondere $(C_1-C_6)$Alkoxy, Alkyl, insbesondere $(C_1-C_4)$Alkyl, Allyloxy, Hydroxy oder Amino, das auch durch Alkyl substituiert sein kann.

Wenn Aryl Phenyl bedeutet, so ist dieser bevorzugt in den Positionen 2 und/oder 4 substituiert, aber auch in Position 3 und/oder 4, sofern der Substituent Alkoxy ist.

Diese genannten Substituenten gelten auch für den Fall, daß Y einen Aralkenylen-Rest bedeutet, insbesondere mit $(C_2-C_4)$Alkenylen. Besonders bevorzugt sind Styryl- und Phenylbutadienylverbindungen.

Zu den über eine Alkenylgruppe an den Triazin-Ring gebundenen aromatischen Resten zählen ganz besonders bevorzugt:

Styryl, 4-Methylstyryl-, 4-Chlorstyryl, 2-Hydroxystyryl, 4-Methoxystyryl-, 4-tert.Butoxystyryl-, 4-Amyloxystyryl-, 4-Allyloxystyryl-, 3-Methoxy-4-hydroxy-styryl-, 2,4-Dimethoxystyryl, 3,4-Dimethoxystyryl-, 4-Dimethylaminostyryl, Phenyl-butadienyl-, 4-Dimethylaminophenyl-butadienyl-, und 3-(N-Ethyl-benzoxazolyl-2-iden)-propen-1-yl-.

Ist Y ein Aryl-Rest, der nicht über eine Alkenyl-Gruppe an den Triazin-Ring gebunden ist, so ist dieser vorzugsweise Phenyl oder Naphthyl oder eine der zwei oder mehrkernigen auch heterocyclischen Verbindungen, die schon oben genannt wurden. Diese können neben den schon obengenannten allgemeinen Substituenten substituiert sein durch Aryl oder $Ar(C_2-C_6)$alkenyl. Eine Substitution mit $Ar(C_2-C_6)$alkenyl ist besonders bevorzugt, wenn der diesen Substituenten tragende aromatische Rest Phenyl ist. Hierunter wird insbesondere ein $Ar(C_2)$-alkenyl-Rest bevorzugt. Bevorzugt wird Position 4 durch $Ar(C_2)$alkenyl substituiert. Für Aryl wird in diesem Fall insbesondere Phenyl eingesetzt.

Beispiele, in denen Y ein ggf. substituiertes Phenyl bedeutet, sind im folgenden zusammengestellt: Phenyl-, 4-Chlorphenyl-, 4-Methoxyphenyl-, 2,4-Dichlorphenyl-, 4-Phenylphenyl-.

Beispiele, in denen Y ein durch $Ar(C_2-C_6)$alkenyl substituiertes Phenyl bedeutet, werden im folgenden aufgezeigt:

4-Styrylphenyl-, 4-p-Methoxystyryl-phenyl-, 4-p-Methylstyryl-phenyl-, 4-p-Chlorstyryl-phenyl-, 4-o-Chlorstyrylphenyl-, 4-m-Chlorstyryl-phenyl-, 4-p-Bromstyryl-phenyl-, 4-m,p-Dimethoxystyryl-phenyl-, 4-p-Ethoxystyryl-phenyl-, 4-m,m,p-Trimethoxystyryl-phenyl-, 4-p-Hexylstyryl-phenyl-, 3-Chlor-4-styryl-phenyl-, 3-Chlor-4-m-chlorstyryl-phenyl-, 3-Chlor-4-p-methylstyryl-phenyl- und 2-Styryl-phenyl-.

Ist Y ein Naphthyl-Rest, so gilt für ihn die allgemeine Formel II

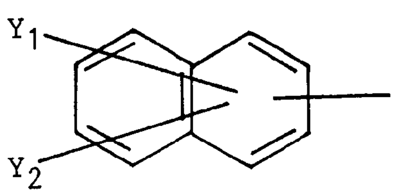

(II)

Hierin bedeuten:

$Y_1$ Wasserstoff oder $-OY_3$, bevorzugt $-OY_3$,

$Y_2$ H, Cl, Br, einen niederen Alkyl-, Alkenyl-, Aryl-, oder einen ggf. substituierten $(C_1-C_4)$-Alkoxyrest, besonders bevorzugt Wasserstoff, einen $(C_1-C_3)$-Alkyl- oder $(C_1-C_3)$-Alkoxyrest und

$Y_3$ einen $(C_1-C_8)$-Alkylrest, der durch Halogen, vorzugsweise Chlor oder Brom, Aryl- oder Aryloxyreste substituiert sein kann und in dem einzelne Methylengruppen durch O- oder S-Brücken ersetzt sein können, einen Cycloalkyl-, Alkenyl-
oder
Arylrest, insbesondere einen $(C_1-C_4)$-Alkyl-
oder
Alkoxyalkylrest
oder
$Y_1$ und $Y_2$ bedeuten gemeinsam einen Alkylenrest, der vorzugsweise mit dem Naphthalinkern unter Ausbildung eines 5- oder 6-gliedrigen Rings verknüpft ist.

Bevorzugt werden auch Verbindungen, in denen der s-Triazinylrest und ein Alkoxyrest in 1,4- oder 2,6-Stellung des Naphthalinkerns angeordnet sind.

Da durch die Kohlenstoffzahl der Alkoxygruppen die photochemische Aktivität der Initiatoren nur unwesentlich beeinflußt wird, ist die Beschränkung auf acht C-Atome in $-OY_3$ nicht als starre Grenze zu betrachten, sondern kann ggf. durchbrochen werden, beispielsweise mit Nonyloxy-, Dodecyloxy- oder Octadecyloxyresten.

Im einzelnen kann Y folgende Naphthyl-Reste umfassen:

Naphth-1-yl-, Naphth-2-yl-, 2-Methoxynaphth-1-yl, 4-Methoxynaphth-1-yl-, 5-Methoxynaphth-1-yl-, 4-Ethoxynaphth-1-yl-, 4-Butoxynaphth-1-yl-, 1-Methoxynaphth-2-yl-, 3-Methoxynaphth-2-yl-, 6-Methoxynaphth-2-yl-, 6-Ethoxynaphth-2-yl-, 4,5-Dimethoxynaphth-1-yl-, 4,7-Dimethoxynaphth-1-yl-, 4-(2-Methoxyethyl)-naphth-1-yl-, 4-(2-Ethoxyethyl)-naphth-1-yl, 4-(2-Butoxyethyl)-naphth-1-yl-, 5-Methyl-6-methoxynaphth-2-yl- und 4-(2-Ethoxy)-ethoxynaphth-1-yl-.

Ebenso besonders bevorzugt sind Verbindungen, in denen $Y_1$ und $Y_2$ gemeinsam einen Alkylenrest bilden, der vorzugsweise mit dem Naphthalinkern unter Ausbildung eines 5- oder 6-gliedrigen Ringes verknüpft ist. Insbesondere ist in diesem Zusammenhang Acenaphth-5-yl- zu nennen.

Andere bevorzugte mehrkernige Reste für Y sind:
4-Methoxy-anthrac-1-yl-, Phenanthr-9-yl-, Benzopyran-3-yl-, Chinol-3-yl- sowie Dibenzothien-3-yl.

Die Verbindungen, die unter die allgemeine Formel I fallen, sind an sich bekannt und in den US-A-3,779,778 (= DE-A-23 06 248); 3,954,475 (= DE-A-22 43 621) und 4,239,850 sowie den DE-A-27 18 259; 29 34 758 und 33 37 024 beschrieben.

Vorzugsweise werden solche Aryl- bzw. Hetaryl-bis-trihalogenmethyl-s-triazine eingesetzt, die ihr Absorptionsmaximum im Bereich von 300 bis 500 nm besitzen.

Es können auch Gemische aus mehreren, insbesondere aus 2 oder 3 Aryl- bzw. Hetaryl-bis-trihalogenmethyl-s-triazinen in dem erfindungsgemäßen Verfahren verwendet werden.

Als Lösemittel für die beschriebenen Triazin-Derivate können fast alle organischen Lösemittel verwendet werden. Beispiele sind aliphatische und aromatische Kohlenwasserstoffe, Halogenkohlenwasserstoffe, Ether, Ester, Ketone, Alkohole, Dimethylformamid usw. Auch Gemische von zwei oder mehreren Lösemitteln können eingesetzt werden. Vorzugsweise verwendet man gut lösende, leicht flüchtige physiologisch wenig bedenkliche Lösemittel wie zum Beispiel Toluol, Tetrahydrofuran, Ethylacetat, Methylethylketon usw.

Die Konzentration der Triazin-Derivate in den Lösemitteln kann in weiten Grenzen schwanken und von 0,1 Gew.-% bis zum Sättigungswert reichen. Besonders bevorzugt sind Lösungen mit Konzentrationen von 2 bis 15 Gew.-%, insbesondere von 2 bis 7 Gew.-%

Die erfindungsgemäß verwendeten Behandlungslösungen können zusätzlich noch kleinere Mengen löslicher Bindemittel sowie auch lösliche Farbstoffe enthalten. Als Bindemittel eignen sich nichtklebrige Polymere wie zum Beispiel Vinylidenchlorid-Copolymerisate, Cyclokautschuke, Polycarbonate, Polyacrylate, Polystyrole, Polyamide usw.

Auf einen Teil Aryl- bzw. Hetaryl-bis-trihalogenmethyl-s-triazin können 0,01 bis 1 Teil, vorzugsweise 0,05 bis 0,5 Teile Bindemittel eingesetzt werden. Bei höherem Bindemittelgehalt resultieren nichtklebrige Überzüge auf den Druckformen, die sich mit Lösemitteln leicht wieder entfernen lassen.

Durch den Zusatz von Bindemitteln kann die Konzentration an Aryl- bzw. Hetaryl-bis-trihalogen-methyl-s-triazin herabgesetzt werden, da die verwendeten Polymere selbst einen Beitrag zur Beseitigung der Klebrigkeit leisten. Im allgemeinen können bis 50 % des Triazin-Derivates durch Bindemittel ersetzt werden, ohne die vorteilhaften Eigenschaften des erfindungsgemäßen Verfahrens in Frage zu stellen. Durch Ersatz eines Teils der Triazin-Derivate durch Bindemittel wird die Behandlungslösung sogar in vorteilhafter Weise kostengünstiger.

Die lichthärtbare Schicht kann als lichthärtbare Verbindung ein Polymeres enthalten, das bei Belichtung selbst oder durch einen lichtempfindlichen Vernetzer zum unlöslichen Zustand vernetzt wird. Sie ist vorzugsweise eine photopolymerisierbare Schicht, die neben dem elastomeren Bindemittel eine ethylenisch ungesättigte radikalisch polymerisierbare Verbindung und einen Photoinitiator enthält, der bei Belichtung freie Radikale bildet. Derartige Gemische sind bekannt und z. B. in den eingangs genannten Druckschriften beschrieben.

Als Elastomere können alle möglichen natürlichen und synthetischen Kautschuktypen eingesetzt werden. Vorzugsweise verwendet man Blockcopolymerisate aus Vinylverbindungen, z. B. Styrol, und Dienen, wie Butadien oder Isopren.

Als polymerisierbare, ethylenisch ungesättigte Monomere verwendet man meist Acryl- oder Methacrylsäureester von mehrwertigen Alkoholen, z. B. Hexandiol-1,6-diacrylat und Hexandiol-1,6-dimethacrylat. Aber auch andere Ester der Acryl- und Methacrylsäure mit ein- oder mehrwertigen Alkoholen können in der Schicht enthalten sein.

Darüber hinaus kann man auch andere ungesättigte Monomere einsetzen, z. B. Vinylester aliphatischer Monocarbonsäuren oder Maleinsäure- und Fumarsäureester usw.

Auf einen Teil elastomeres Bindemittel verwendet man 0,05 bis 0,3 Teile ethylenisch ungesättigtes Monomeres.

Als Photoinitiatoren in dem Gemisch können eine Vielzahl von Substanzen Verwendung finden. Beispiele sind solche, die sich vom Grundkörper der Benzophenone, Benzoine, Benzile, Benzilmonoketale, des Fluorenons, Thioxanthons, der Mehrkernchinone, Acridine und Chinoxaline ableiten; ferner Trichlormethyl-s-triazine, Trihalogenmethylgruppen enthaltende Carbonylmethylenheterocyclen gemäß DE-A 33 33 450 oder Acylphosphinoxidverbindungen, wie sie z. B. in der DE-A 31 33 419 beschrieben sind.

Die Initiatoren werden allgemein in einer Menge von 0,01 bis 10, vorzugsweise von 0,05 bis 5 Gew.-%, bezogen auf die nichtflüchtigen Bestandteile der Schicht, eingesetzt.

Die photopolymerisierbare Schicht kann außerdem noch Zusatzstoffe enthalten, die die Lagerfähigkeit, das Kopierverhalten und andere Eigenschaften verbessern. Übliche Zusatzstoffe sind z. B. thermische Polymerisationsinhibitoren, Farbstoffe, Antioxidantien, Antiozonantien, Weichmacher und Füllstoffe.

Die photopolymerisierbare Schicht kann einheitlich sein oder aus mehreren übereinanderliegenden Schichten verschiedener Zusammensetzung bestehen. Beispielsweise kann man zweilagige photopolymerisierbare Schichten verwenden, bei denen die dem Schichtträger abgewandte Lage nach der Polymerisation eine höhere Härte aufweist als die dem Träger zugewandte Lage. Die gesamte photopolymerisierbare Schicht hat im allgemeinen eine Dicke von 0,05 bis 7, vorzugsweise 0,2 bis 5 mm.

Über der photopolymerisierbaren Schicht können sich in bekannter Weise noch eine dünne, nicht klebende, im Entwickler lösliche Polymerschicht, z. B. aus löslichen Polyamiden, und eine dickere, abziehbare Schutzfolie befinden. Die Polymerschicht hat im allgemeinen eine Dicke von 1 bis 20 µm, die Schutzfolie eine von etwa 50 bis 200 µm.

Als dimensionsstabile Trägerfolien für die Photopolymerschicht verwendet man bevorzugt 50 bis 300 µm dicke transparente Kunststoffolien, z. B. aus Polyestern, Polycarbonaten, Polyimiden oder dgl. Besonders bevorzugt werden Polyethylenterephthalatfolien. Falls der Träger zwischen einer Photopolymerschicht und einer gummielastischen Basisplatte angeordnet werden soll, kann die Dicke auch geringer sein, z. B. bis herab zu 10 µm. Auf der Oberfläche der Polyethylenterephthalatfolie befindet sich in der Regel eine Klebestoff- oder Haftvermittler-Schicht.

Die Herstellung der gummielastischen 0,5-7 mm dicken photopolymerisierbaren Schicht kann in bekannter Weise durch Eindampfen einer Lösung der Komponenten, durch Verpressen einer homogenen Knetmasse zwischen parallelen Platten oder durch Extrudieren durch eine Breitschlitzdüse und nachfolgendes Kalandrieren der Bahn erfolgen. Bei Herstellung nach der letztgenannten Methode ist es von Vorteil, die Schicht im heißen Zustand schon im Kalander mit der haftvermittelten Trägerfolie und der Schutzfolie zu vereinigen.

Soll auf die Rückseite der Trägerfolie eine nicht lichtempfindliche Weichgummi- oder elastische Schaumstoff-Platte aufgebracht werden, dann muß die Trägerfolie beidseitig mit der Haftschicht versehen werden. Das Aufbringen der rückseitigen Haftschicht kann vor, während oder nach dem Verbinden mit der photopolymerisierbaren Schicht geschehen. Falls die Herstellung des Verbunds nicht in einem Arbeitsgang erfolgt, muß die freiliegende Haftschicht beim Laminiervorgang mit einer leicht abziehbaren Folie geschützt werden, damit die Walzen des Laminators nicht verschmutzt werden.

Die Verarbeitung des mehrschichtigen Flexodruckplattenmaterials zu gebrauchsfertigen Druckformen geschieht in bekannter Weise. Zunächst erzeugt man einen Druckplattensockel durch gleichmäßige Belichtung des Elementes durch die Trägerfolie hindurch. Danach belichtet man die Gegenseite - nach Abziehen der Schutzfolie - durch eine Negativ-Filmvorlage. Anschließend wäscht man die unbelichteten, nicht gehärteten Partien mit einem geeigneten Entwickler, z. B. einem Gemisch aus Perchlorethylen und n-Butanol, aus.

Die in dieser Weise hergestellten klebrigen elastomeren Druckformen werden zur Vervollständigung der Vernetzungsreaktion zunächst in bekannter Weise nachbelichtet - zum Beispiel 10 Minuten lang in einem 320 W Röhrenbelichtungsgerät, wie es üblicherweise zur Herstellung der Druckformen verwendet wird - und anschließend zur Beseitigung der Klebrigkeit der erfindungsgemäßen Behandlung unterzogen. Die Nachbelichtung muß vor der Nachbehandlung erfolgen, weil das bei der erfindungsgemäßen Nachbehandlung auf der Druckform befindliche Aryl- bzw. Hetarylbis-trihalogen-methyl-s-triazin das für die Weitervernetzung notwendige aktinische Licht in entscheidendem Ausmaß absorbieren würde.

Die erfindungsgemäße Behandlung der nachbelichteten, noch klebrigen Druckform kann auf verschiedene Weise erfolgen. Man kann die Aryl- bzw. Hetaryl-bis-trihalogenmethyl-s-triazin-Lösungen auf die Druckform aufspritzen, aufstreichen oder mit geeigneten weichen, saugfähigen Walzen aufrollen. Man kann die Druckformen aber auch in den Lösungen baden. Die Behandlungsdauer kann 1 Sekunde bis viele Minuten betragen. Sie ist umso kürzer, je konzentrierter die verwendeten Lösungen sind. In der Regel reicht ein Eintauchen für ca. 10 Sekunden bei ca. 5 Gew.-%igen Lösungen aus.

Nach der Behandlung mit den Lösungen werden die Druckformen getrocknet. Bei Verwendung leicht flüchtiger Lösemittel kann dies durch kurzzeitiges Liegenlassen an der Luft erfolgen. Man kann aber auch die Druckformen mit warmer Luft oder in einem Wärmeschrank trocknen. Dabei muß darauf geachtet werden, daß nicht die Zersetzungstemperaturen der Aryl-bis-trihalogenmethyl-s-triazine erreicht werden. Temperaturen von unter 120° C werden bevorzugt.

Die mit einer Aryl- bzw. Hetaryl-bis-trihalogenmethyl-s-triazin-Lösung behandelten Druckformen besitzen auch nach Verdunsten des Lösungsmittels vielfach noch deutliche Klebrigkeit. Vollständig klebefrei werden sie erst, wenn mit langwelligem UV-Licht kurzzeitig nachbelichtet wird. Alle Lichtquellen, die Licht dieser Art

aussenden, können verwendet werden. Genannt werden zum Beispiel Röhrengeräte, Quecksilberlampen und Metallhalogenidlampen. Diese Lampen haben im üblich verwendeten Abstand eine Leistung von ca. 1 bis 5 mW/cm$^2$. Bei Verwendung dieser Lampen mit Lichtenergien von 350 bis 500 mJ/cm$^2$ sind Nachbelichtungszeiten von 2 bis 5 min erforderlich.

Die zur Nachbelichtung der behandelten Druckformen benötigte Lichtmenge beträgt nur etwa 10 % der zur Reliefausbildung benötigten Lichtmenge.

Der Chemismus der Reaktion, die zur Beseitigung der Klebrigkeit führt, ist noch nicht geklärt. Die Oberfläche der Druckform erfährt bei der Behandlung eine bleibende Veränderung. Nachträgliches Abwischen mit Lösemitteln führt nicht zum klebrigen Zustand zurück.

Die folgenden Beispiele beschreiben bevorzugte Ausführungsformen der Erfindung. Alle Prozente und Mengenverhältnisse sind, wenn nichts anderes angegeben ist, in Gewichtseinheiten zu verstehen. Gewichtsteile (Gt) und Volumteile (Vt) stehen im Verhältnis von g zu ccm.

Beispiele 1 bis 5

Fünf verschiedene handelsübliche Flexodruckplatten wurden in bekannter Weise entsprechend den Angaben in der Beschreibung bildmäßig belichtet und anschließend die unbelichteten, nicht gehärteten Partien mit einem jeweils geeigneten handelsüblichen Entwickler ausgewaschen. Anschließend wurde 10 min lang mit einem 320 W Röhrenbelichtungsgerät nachbelichtet. Die noch klebrigen Druckformen wurden dann in erfindungsgemäßer Weise mit einer 6 Gew.-%igen Lösung von 2-Stilbenyl-4,6-bis-trichlormethyl-s-triazin in Toluol für 10 s behandelt, d.h. in eine solche Lösung getaucht, kurzzeitig getrocknet und anschließend nochmals, allerdings für 2 min, mit dem beschriebenen Röhrenbelichtungsgerät nachbelichtet.

Die Platten wiesen keine Oberflächenklebrigkeit auf. Außerdem zeigten sie eine relativ hohe Resistenz gegenüber Ozon. Um dies zu testen, wurden die Druckplatten in einem Kasten bei Raumtemperatur der Luft eines Ozongehaltes von 0,4 ppm ausgesetzt.

Eine Zusammenfassung der Ergebnisse ist in der Tabelle zu finden.

Vergleichsbeispiele 1 bis 5

Die in den Beispielen 1 bis 5 verwendeten handelsüblichen Flexodruckplatten wurden, wie in den Beispielen 1 bis 5 beschrieben belichtet und entwickelt. Anschließend wurden die Druckformen in bekannter Weise für 5 min in 0,4 Gew.-%ige wäßrige Bromlösung getaucht, 10 min lang mit Wasser gespült und abschließend für 10 min mit einem 320 W Röhrenbelichtungsgerät nachbelichtet.

Auch diese Platten wiesen keine Oberflächenklebrigkeit auf. Allerdings zeigten sie, wenn sie, wie in den Beispielen 1 bis 5 angegeben wurde, mit ozonhaltiger Luft behandelt wurden, eine weitaus geringere Resistenz gegenüber Ozon als dies bei den erfindungsgemäß hergestellten Platten anzutreffen war.

Eine Zusammenfassung der Ergebnisse zeigt Tabelle I:

Tabelle

Die in dieser Tabelle zusammengestellten Zeitangaben geben die Zeit wieder, nach der erste Risse auf den mit ozonhaltiger Luft behandelten Platten auftraten.

| Flexodruckplatte | Vergleichsbeispiel | Behandlung mit Brom-Lösung | Beispiel | Behandlung mit 2-Stilbenyl-4,6-bis-trichlormethyl-s-triazin-Lösung |
|---|---|---|---|---|
| ® Cyrel HLS | V 1 | 2 min | 1 | 4 h |
| ® Cyrel HOS | V 2 | 10 min | 2 | 10 h |
| ® Cyrel PQS | V 3 | 0,5 min | 3 | 0,5 h |
| ® Nyloflex FA | V 4 | 2 min | 4 | 5 h |
| ® Flexlight KOR | V 5 | 1 min | 5 | 3 h |

Beispiel 6

Die handelsübliche Flexodruckplatte® Cyrel HLS (DuPont) wurde, wie in den Beispielen 1 bis 5 angegeben, zu einer Flexodruckform verarbeitet. Die Nachbelichtungszeit betrug 10 min. Daraufhin wurde die Druckform für 20 s mit einer Lösung aus 4 Gew.-% 2-Stilbenyl-4,6-bis-trichlormethyl-s-triazin und 1 Gew.-% Cyclokautschuk in Toluol behandelt. Nachdem für 2 min mit einem 120 W Röhrenbelichtungsgerät nachbelichtet worden war, resultierte eine nicht-klebende Druckform mit ausgezeichneter Resistenz gegenüber ozonhaltiger Luft.

Beispiele 7 bis 9

Drei handelsübliche Flexodruckplatten vom Typ® Cyrel HLS wurden entsprechend den Beispielen 1 bis 5 belichtet, entwickelt und nachbelichtet. Anschließend wurden die Platten jeweils mit einem der folgenden Aryl-bis-trichlormethyl-s-triazine, jeweils als 5 Gew.-%ige Lösung in Toluol, für 15 s behandelt.

| Beispiel | Aryl-bis-trichlormethyl-s-triazin |
|---|---|
| 7 | 2-Stilbenyl-4,6-bis-trichlormethyl-s-triazin |
| 8 | 2-(4-Ethoxy)naphth-1-yl-4,6-bis-trichlormethyl-s-triazin |
| 9 | 2-Acenaphth-5-yl-4,6-bis-trichlormethyl-s-triazin |

Die Druckformen wurden getrocknet und 3 min in einem 120 W Röhrenbelichtungsgerät nachbelichtet.

In allen Fällen konnten nicht klebende und gegen ozonhaltige Luft resistente Druckformen erhalten werden. Auch Gemische dieser Triazin-Derivate lieferten gute Ergebnisse. Das Mischungsverhältnis kann in breiten Grenzen variiert werden, jeweils nach den Erfordernissen der speziell eingesetzten handelsüblichen Flexodruckplatte.

Beispiele 10 bis 12

Die handelsüblichen Flexodruckplatten vom Typ® Cyrel HLS wurden entsprechend den Angaben in den Beispielen 1 bis 5 belichtet, entwickelt und nachbelichtet. Anschließend wurden die Druckformen mit einer 6 Gew.-%igen Lösung von 2-Stilbenyl-4,6-bis-trichlormethyl-s-triazin in Toluol behandelt.

In Abhängigkeit vom jeweils verwendeten Belichtungsgerät waren folgende Belichtungszeiten bzw. Lichtenergien notwendig, um nicht klebende und gegen ozonhaltige Luft hervorragend beständige Druckformen zu erzielen.

| Beispiel | Belichtungsgerät | Belichtungszeit | Energie |
|---|---|---|---|
| 10 | 120 W-Röhrengerät ($4{,}0\ mW/cm^2$) | 2 min | $480\ mJ/cm^2$ |
| 11 | 5 kW Metallhalogenidlampe im Abstand von 140 cm ($2{,}4\ mW/cm^2$) | 3 min | $430\ mJ/cm^2$ |
| 12 | 125 W Quecksilberdampflampe im Abstand von 35 cm ($1{,}2\ mW/cm^2$) | 5 min | $360\ mJ/cm^2$ |

-------

**Patentansprüche**

1. Verfahren zur Nachbehandlung von entwickelten Reliefdruckformen für den Flexodruck, die in bekannter Weise nachbelichtet werden, dadurch gekennzeichnet, daß die Reliefdruckformen mit einer Lösung im wesentlichen bestehend aus einem organischen Lösemittel und einem gelösten Aryl- bzw. Hetaryl-bis-trihalogenmethyl-s-triazin der allgemeinen Formel I behandelt werden,

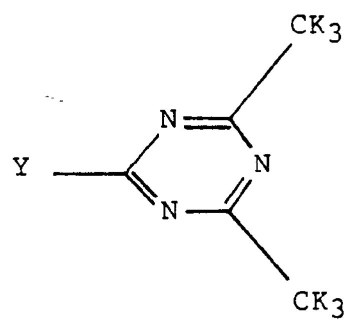

(I)

die Reliefdruckform getrocknet und anschließend kurzzeitig mit UV-Licht nachbelichtet wird, wobei
Y einen ggf. substituierten aromatischen oder heterocyclischen aromatischen, ggf. über eine konjugierte Alkenylenkette, insbesondere ($C_2$-$C_6$)Alkenylen, gebundenen Rest oder einen ggf. partiell hydrierten Rest, der über ein ungesättigtes Ring-C-Atom gebunden ist und wiederum ggf. substituiert sein kann, insbesondere durch Aryl oder Ar($C_2$-$C_6$)alkenylen, und
K ein Chlor-, Brom oder Jodatom, vorzugsweise ein Chloratom,
bedeuten.

2. Verfahren nach Anspruch 1, dadurch gekennzeichnet, daß die Aryl- bzw. Hetaryl-bis-trihalogenmethyl-s-triazinverbindung im Lösemittel in einer Konzentration von 0,1 Gew.-% bis zum Sättigungswert, insbesondere von 2 bis 15 Gew.-%, enthalten ist.

3. Verfahren nach den Ansprüchen 1 oder 2, dadurch gekennzeichnet, daß Gemische von verschiedenen, insbesondere von 2 oder 3 Aryl- bzw. Hetaryl-bis-trihalogenmethyl-s-triazinen verwendet werden.

4. Verfahren nach einem oder mehreren der Ansprüche 1 bis 3, dadurch gekennzeichnet, daß die Aryl- bzw. Hetaryl-bis-trihalogenmethyl-s-triazine ein Absorptionsmaximum im Bereich von 300 bis 500 nm besitzen.

5. Verfahren nach einem oder mehreren der Ansprüche 1 bis 4, dadurch gekennzeichnet, daß die Nachbehandlungslösung zusätzlich ein Bindemittel enthält.

6. Verfahren nach Anspruch 5, dadurch gekennzeichnet, daß das Bindemittel ein nichtklebriges Polymeres ist, das zu 0,01 bis 1 Teil, insbesondere 0,05 bis 0,5 Teile auf ein Teil Aryl- bzw. Hetaryl-bis-trihalogenmethyl-s-triazin in der Nachbehandlungslösung enthalten ist.

7. Verfahren nach einem oder mehreren der Ansprüche 1 bis 6, dadurch gekennzeichnet, daß als Lösemittel aliphatische oder aromatische Kohlenwasserstoffe, Halogenkohlenwasserstoffe, Ether, Ester, Ketone und Alkohole verwendet werden.

## Claims

1. A method for the post-treatment of developed relief printing forms for flexographic printing, which are reexposed in a customary manner,
characterized in that
the relief rooting forms are treated with a solution consisting essentially cf an organic solvent and a dissolved aryl- or hetaryl-bis-trihalogenomethyl-s-trazine of the general formula (I)

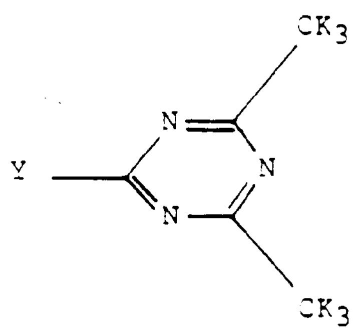

(I)

the relief printing forms are dried, and subsequently briefly reexposed to UV-light, wherein Y denotes an optionally substituted aromatic or heterocyclic aromatic radical, optionally linked by a conjugated alkenylen chain, particularly ($C_2$-$C_6$) alkenylen, or an optionally partially hydrogenated radical which is linked by an unsaturated carbon atom of the ring and which optionally can be substituted again, particularly by aryl or Ar($C_2$-$C_6$) alkenylen, and K denotes a chlorine, bromine, or iodine atom, preferably a chlorine atom.

2. A method according to claim 1,
characterized in that
the aryl- or hetaryl-bis-trihalogenomethyl-s-trazine compound is contained in the solvent in a concentration from 0,1 weight percent to the saturation value, particularly from 2 to 15 weight percent.

3. A method according to claims 1 or 2,
characterized in that
mixtures of different, in particular of 2 or 3 aryl- or hetaryl-bis-trihalogenomethyl-s-trazines are used.

4. A method according to one or more of claims 1 to 3,
characterized in that
the aryl- or hetaryl-bis-trihalogenomethyl-s-trazines have absorption peaks in the range from 300 to 500 nm.

5. A method according to one or more of claims 1 to 4,

characterized in that
the post-treatment solution contains additionally a binder.

6. A method according to claim 5,
characterized in that
the binder is a non-tacky polymer which is contained in the post-treastment solution in 0,01 to 1 parts, particularly 0,05 to 0,5 parts per part of the aryl- or hetaryl-bis-trihalogenomethyl-s-trazine.

7. A method according to one or more of claims 1 to 6,
characterized in that
aliphatic or aromatic hydrocarbons, halogenated hydrocarbons, ethers, esters, ketones, and alcohols are used as solvents.

## Revendications

1. Procédé de traitement secondaire de formes d'impression à relief développé destiné à l'impression flexographique qui ont été, d'une façon connue, soumises à une exposition secondaire, caractérisé en ce que les formes d'impression en relief sont traitées par une solution constituée essentiellement d'un solvant organique et d'une aryl- et/ou aryle hétérocyclique-bis-trihalogénométhyl-s-triazine dissoute répondant à la formule générale I:

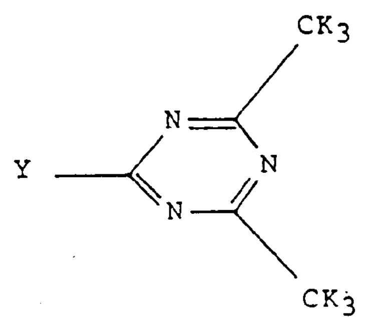

(I)

les formes en relief sont séchées et ensuite brièvement soumises à une exposition secondaire à une lumière UV,

Y représentant un radical éventuellement substitué, aromatique ou aromatique-hétérocyclique éventuellement lié par une chaîne alkényle conjuguée, notamment alkénylène en $C_2$ à $C_6$ ou un reste éventuellement partiellement hydrogéné qui est lié par un atome de C du cycle insaturé et qui peut à nouveau être éventuellement substitué, notamment par un radical aryle ou aralkénylène en $C_2$ à $C_6$; et

K représente un atome de chlore, de brome ou d'iode, de préférence un atome de chlore.

2. Procédé selon la revendication 1, caractérisé en ce que la liaison aryle ou aryle hétérocyclique-bistrihalogénométhyl-s-triazine est contenue dans un solvant à une concentration de 0,1% en poids jusqu'à une valeur équivalente à la saturation, notamment 2 à 15% en poids.

3. Procédé selon l'une quelconque des revendications 1 ou 2, caractérisé en ce que l'on utilise des mélanges de plusieurs triazines, notamment de 2 ou 3, aryl- et aryle hétérocyclique-bis-trihalogénométhyl-s-triazines.

4. Procédé selon l'une ou plusieurs des revendications 1 à 3, caractérisé en ce que les aryl- et aryle hétérocyclique-bis-trihalogénométhyl-s-triazine possèdent un maximum d'absorption dans le domaine de 300 à 500 nm.

5. Procédé selon l'une ou plusieurs des revendications 1 à 4, caractérisé en ce que la solution de traitement secondaire contient en outre un agent liant.

6. Procédé selon la revendication 5, caractérisé en ce que l'agent liant est un polymère non collant qui est contenu à concurrence de 0,01 à 1 partie, notamment 0,05 à 0,5 parties pour 1 partie d'aryl- et/ou d'aryle

hétérocyclique-bis-trihalogénométhyl-s-triazine dans la solution de traitement secondaire.

7. Procédé selon l'une ou plusieurs des revendications 1 à 6, caractérisé en ce que l'on emploie comme solvants des hydrocarbures aliphatiques ou aromatiques, des hydrocarbures halogénés, des éthers, des esters, des cétones et des alcools.